**Europäisches Patentamt**

**European Patent Office**

**Office européen des brevets**

(11) Veröffentlichungsnummer: **0 328 045**
**A1**

# EUROPÄISCHE PATENTANMELDUNG

(21) Anmeldenummer: **89102079.4**

(22) Anmeldetag: **07.02.89**

(51) Int. Cl.⁴ **F24J 2/06 , F24J 2/04 , H01L 31/00**

(30) Priorität: **09.02.88 DE 3803904**

(43) Veröffentlichungstag der Anmeldung:
**16.08.89 Patentblatt 89/33**

(84) Benannte Vertragsstaaten:
**AT CH DE ES FR GB GR IT LI NL**

(71) Anmelder: **Winter, Helmut**
**Friedrich-Ebert-Strasse 50**
**D-6307 Linden-Grossenlinden(DE)**

Anmelder: **Grimm, Arnold**
**Krautgarten 12**
**D-6405 Eichenzell 7(DE)**

(72) Erfinder: **Grimm, Arnold**
**Krautgarten 12**
**D-6405 Eichenzell 7(DE)**

(54) **Strahlungssammler.**

(57) Strahlungssammler mit einem rohrförmigen Energiewandler (1), welcher von mehreren optischen Elementen (2), welche radial von diesem vorstehen, umgeben wird. Die optischen Elemente (2) sind, ebenso wie ein sie umgebendes äußeres Rohr (6), aus einem strahlungsdurchlässigen Material gefertigt und schließen Zwischenräume (5) ein. Die Erfindung ist sowohl bei Wärmetauschern als auch im Bereich der Photovoltaik verwendbar.

EP 0 328 045 A1

FIG. 1

# Strahlungssammler

Die Erfindung betrifft einen Strahlungssammler mit einem rohrförmigen Energiewandler.

Es ist ein rohrförmiger Energiewandler bekannt, beispielsweise aus der DE-OS 35 09 601, welcher in Form eines Wärmetauscherrohrs ausgebildet ist und von einem strahlungsdurchlässigen Rohr umgeben ist, welches eine linsenartige Wirkung ausübt, um die eintretenden Lichtstrahlen, zumindest zum Teil in Richtung auf den rohrförmigen Energiewandler zu fokussieren. Das strahlen- oder lichtdurchlässige Rohr bildet somit eine Zylinderlinse. Derartige Zylinderlinsen sind in ihrer Wirkung begrenzt, da die Konzentrationswirkung, bedingt durch unterschiedliche Lichteinfallwinkel und bedingt durch die vorgegebenen Krümmungsradien, beschränkt sind.

Die bekannten Zylinderlinsen wurden beispielsweise verwendet, um Meerwasser oder Brackwasser zu entsalzen oder um destilliertes Wasser oder Trinkwasser zu erzeugen, wobei dies unter Verwendung der Sonnenenergie erfolgte, welche über die Zylinderlinsen einem rohrförmigen Energiewandler zugeleitet wurde.

Bei den bisher bekannten Zylinderlinsen erwies es sich als nachteilig, daß diese, bedingt durch das zugrundeliegende physikalische Wirkprinzip, einen sehr geringen Konzentrationsfaktor (Energieverdichtung bezogen auf die Energiewandleroberfläche, d.h. also auf die Oberfläche des Wärmetauscherrohres) aufweisen. Zur Erhöhung des Konentrationsfaktors wurde versucht, einen Teil des Rohres zu verspiegeln, um auf diese Weise die Lichtstrahlen, welche nicht direkt auf das Wärmetauscherrohr treffen, entsprechend zu reflektieren. Auch dies hat sich als nur bedingt wirksam erwiesen, da in dem verspiegelten Bereich ein Lichteintritt, beispielsweise durch diffuses Licht, verhindert wird und da der verspiegelte Bereich die Verluste beim Durchgang des Lichtes durch die Zylinderlinse nicht ausgleichen kann.

Der Erfindung liegt die Aufgabe zugrunde, einen Strahlungssammler der eingangs genannten Art zu schaffen, welcher bei einfachem Aufbau, betriebssicherer Wirkungsweise und geringen Produktionskosten eine wirkungsvolle Zuleitung von Strahlen zu einem rohrförmigen Energiewandler ermöglicht und einen hohen Konzentrationsfaktor gewährleistet.

Erfindungsgemäß wird die Aufgabe dadurch gelöst, daß der Strahlungssammler mehrere, gleichmäßig um den Umfang des Energiewandlers angeordnete, zueinander beabstandete, aus einem strahlungsdurchlässigen Material gefertigte optische Elemente umfaßt, welche jeweils symmetrisch zu einer radialen, die Mittelachse des Energiewandlers umfassenden Ebene ausgebildet sind.

Der erfindungsgemäße Strahlungssammler zeichnet sich durch eine Reihe erheblicher Vorteile aus. Durch die um den Umfang gleichmäßig verteilten optischen Elemente ist es möglich, Strahlung, insbesondere Sonnenstrahlung auf allen Seiten des Strahlungssammlers zu nutzen und dem rohrförmigen Energiewandler zuzuführen. Es ist somit möglich, den Strahlungssammler in besonders wirkungsvoller Weise zur Einstrahlrichtung der Sonnenstrahlen auszurichten, wobei es sich als besonders vorteilhaft erweist, diesen im wesentlichen senkrecht zur Bewegungsrichtung der Sonne anzuordnen.

Ein weiterer Vorteil des erfindungsgemäßen Strahlungssammlers liegt in der einfachen Herstellbarkeit und in der geringen benötigten Materialmenge. So ist es beispielsweise möglich, den Strahlungssammler aus Kunststoff mittels eines Extrudierverfahrens herzustellen.

Durch die mehreren optischen Elemente erfolgt jeweils eine Brechung der Lichtstrahlen beim Durchgang durch die Grenzfläche zwischen dem optischen Element und der Umgebung. Durch geeignete Ausgestaltung des Oberfläche der optischen Elemente ist es möglich, durch mehrfache Lichtbrechung einen Großteil bzw. fast alle eintreffenden Strahlen auf das Energiewandlerrohr zu lenken. Auf diese Weise ist es möglich, eine direkte Sonneneinstrahlung als auch eine diffuse Beleuchtung auszunutzen. Bei dem erfindungsgemäßen Strahlungssammler ist es hinsichtlich seiner Ausrichtung zum Sonnenstand lediglich erforderlich, diesen im wesentlichen senkrecht zur Sonnenbahn anzuordnen. Es ist nicht erforderlich, den Strahlungssammler direkt dem jeweils aktuellen Sonnenstand nachzuführen, so wie dies bei üblichen Sonnenkollektoren erforderlich ist. Es können somit die sonst benötigten mechanischen- und Steuerungseinrichtungen entfallen, wodurch sich sowohl die Gesamtkosten als auch die Zuverlässigkeit der Anlage beträchtlich erhöhen.

Bei dem erfindungsgemäßen Strahlungssammler trifft nämlich die direkte Sonnenstrahlung stets in einem Winkel von annähernd 90° auf den Strahlungssammler. Auf diese Weise läßt sich erfindungsgemäß eine besonders hohe Energiedichte an den Energiewandler erreichen. Durch die erfindungsgemäßen optischen Elemente wird nicht nur eine Umlenkung der einzelnen Lichtstrahlen vorgenommen, vielmehr ist es möglich, mittels der Mehrfachbrechung eine Fokussierung der einzelnen Lichtstrahlen zu erreichen.

Bei dem erfindungsgemäßen Strahlungssammler erweist es sich, da dieser nicht dem jeweiligen aktuellen Sonnenstand nachgeführt werden muß, als besonders vorteilhaft, daß es nunmehr möglich ist, diesen stationär aufzustellen. Eine Anpassung an die verschiedenen Sonnenstände in Abhängigkeit von den Jahreszeiten läßt sich auf sehr einfache Weise dadurch erreichen, daß der Strahlungssammler in seiner Neigung zur Horizontalen so ausgebildet wird, daß bei einem niedrigsten Sonnenstand ein Einfallwinkel von 90° gewährleistet ist. Hierdurch ist es möglich, auch in den Wintermonaten ein Höchstmaß an Sonnenenergie umzuwandeln. Es ist jedoch mit dem erfindungsgemäßen Strahlungssammler auch möglich, einen mittleren Neigungswert zur Horizontalen zu wählen, um einen möglichst guten Wirkungsgrad über das Jahr zu gewährleisten.

In vorteilhafter Weise sind die Zwischenräume zwischen den optischen Elementen mit Gas gefüllt oder evakuiert. Auf diese Weise ist es möglich, die Brechungsindizes den jeweiligen geometrischen Bedingungen sowie den jeweiligen terrestrischen Anforderungen anzupassen. Dabei kann es sich auch als vorteilhaft erweisen, wenn die optischen Elemente gegen die Außenfläche des Energiewandlers anliegen, da in einem solchen Falle eine nochmalige Reflexion der Strahlung beim Auftreffen auf den Energiewandler verhindert werden kann.

Als besonders günstig kann es sich weiterhin herausstellen, daß die optischen Elemente innerhalb eines strahlungsdurchlässigen, zum rohrförmigen Energiewandler konzentrischen Rohrs angeordnet sind. Durch eine derartige Ausgestaltung ergibt sich zum einen eine besonders hohe mechanische Festigkeit des Strahlungssammlers, da Beschädigungen oder Verschmutzungen der Lichtbrechungsflächen der optischen Elemente verhindert werden können. Weiterhin kann es besonders günstig sein, die optischen Elemente einstückig mit dem Rohr auszubilden. Auf diese Weise kann eine besonders einfache und rationelle Fertigung des gesamten Strahlungssammlers erfolgen. Weiterhin es es möglich, die Lichtbrechungseffekte beim Durchdringen des die optischen Elemente umgebenden Rohres in vorteilhafter Weise auszunutzen.

Eine günstige Weiterbildung der Erfindung kann auch dadurch gegeben sein, daß der Außendurchmesser der optischen Elemente, bezogen auf die Mittelachse des rohrförmigen Energiewandlers zu dem Außendurchmesser des Energiewandlers in einem Verhältnis von mindestens 2:1 steht. Durch dieses Abmessungsverhältnis ist es auf besonders einfache Weise möglich, nicht nur eine Umlenkung, sondern auch eine Konzentration der auf den Strahlungssammler auftreffenden Strahlung zu erreichen und damit den Wirkungsgrad bzw. den Konzentrationsfaktor zu erhöhen.

Erfindungsgemäß kann vorgesehen sein, die optischen Elemente an einigen ihrer Seitenflächen zu verspiegeln. Dies kann sich dann als vorteilhaft erweisen, wenn einige der Bereiche der optischen Elemente, bedingt durch den Brechungsindex, ein Austreten von Lichtstrahlung ermöglichen würden.

Eine besonders günstige Ausgestaltung des erfindungsgemäßen Strahlungssammlers ist dadurch gegeben, daß der Energiewandler mit photovoltaischen Zellen versehen ist. Diese photovoltaischen Zellen können mit einem Wärmetauscherrohr in Kontakt stehen, was sich insbesondere im Hinblick auf die Kühlung und die Erhöhung des Wirkungsgrades der photovoltaischen Zellen als besonders günstig erweisen kann. Dabei ist es insbesondere bei Verwendung des erfindungsgemäßen Strahlungssammlers möglich, die Gesamtfläche der benötigten photovoltaischen Zellen um den Konzentrationsfaktor zu verringern, wodurch zum einen die Kosten erheblich gesenkt werden können und wodurch zum anderen, bezogen auf die für die Installation derartiger Strahlungssammler vorhandene Fläche, eine wesentlich höhere Energieausbeute erzielt werden kann.

Erfindungsgemäß ist es, wie bereits erwähnt, möglich, die photovoltaischen Zellen mit einem Wärmetauscherrohr in Kontakt zu bringen, so daß diese, bedingt durch die an das Wärmetauschermedium abgegebene Energie, gekühlt werden. Auf diese Weise ist es möglich, zwei Effekte zu kombinieren, nämlich zum einen die Gewinnung elektrischen Stromes durch die photovoltaischen Zellen, als auch eine zusätzliche Aufheizung eines Wärmetauschermediums. Eine günstige Ausgestaltung kann auch dadurch gegeben sein, daß die photovoltaischen Zellen auf einem Trägerrohr befestigt sind, welches passend in ein lichtdurchlässiges, zentrisch zu den optischen Elementen angeordnetes Rohr eingeführt ist. Dies erleichtert zum einen in beträchtlichem Maße die Herstellung des Strahlungssammlers und ermöglicht es, die photovoltaischen Zellen, beispielsweise zu Reinigungs-oder Wartungszwecken, zu entfernen.

Erfindungsgemäß sind die optischen Elemente in vorteilhafter Weise so ausgebildet, daß diese sich über die gesamte Länge des rohrförmigen Energiewandlers erstrecken und über die Länge jeweils einen gleichbleibenden Querschnitt aufweisen. Dabei kann es sich als besonders vorteilhaft erweisen, die optischen Elemente mit einem im wesentlichen dreieckförmigen Querschnitt auszubilden, wobei das Dreieck zwei gleichschenkelige Seiten aufweist und mit der durch diese Seiten gebildeten Spitze gegen den rohrförmigen Energiewandler anliegt. Zur Erzielung einer kreisrunden Außenfläche können die jeweiligen Außenseiten der Elemente konkav ausgebildet sein. Bei einer derartigen Ausgestaltung ergeben sich zwischen den einzelnen optischen Elementen dreieckförmige Zwischenräume. In einer anderen Ausgestaltungsform kann es sich als günstig erweisen, die optischen Elemente im wesentlichen mit einem rechteckförmigen Querschnitt auszubilden, wobei die radiale Abmessung wesentlich größer ist als die Breite des einzelnen optischen Elements. Die dem rohrförmigen Energiewandler zugewandte Fläche kann in vorteilhafter Weise konkav ausgebildet sein, während die radial außenliegende Fläche konvex ausgebildet sein kann. Weiterhin ist es möglich, ebenso wie bei den vorstehend beschriebenen dreieckförmigen Elementen, diese an ihren radialen außenliegenden Bereichen mittels eines äußeren Rohres miteinander zu verbinden, um auf diese Weise die zwischen den optischen Elementen gebildeten Zwischenräume zur Umgebung hin abzudichten. Eine weitere vorteilhafte Ausgestaltungsmöglichkeit der optischen Elemente liegt darin, daß diese einen Querschnitt aufweisen, der aus einem inneren und einem äußeren Trapezbereich gebildet ist, wobei der innere Trapezbereich an der dem rohrförmigen Energiewandler zugewandten Seite konkav ausgebildet ist und sich radial nach außen hin verjüngt. Im Bereich der Hälfte der radialen Erstreckung des optischen Elementes geht dieses in einen zweiten trapezförmigen Bereich über, welcher sich radial nach außen hin verbreitert und an seiner Außenseite konvex ausgebildet ist, um die Ausbildung einer rohrförmigen Außengestalt zu ermöglichen. Dabei können die optischen Elemente wiederum einstückig mittels eines äußeren Rohres miteinander verbunden sein.

Erfindungsgemäß ist es auch möglich, die optischen Elemente mit einem rhombusförmigen Querschnitt zu versehen, wobei in bevorzugter Weise die radial außenliegende und die radial innenliegende Spitze des Rhombus weggelassen und durch einen konkaven bzw. konvexen Bereich ersetzt wird. Auch derartige rhombusförmige optische Elemente können in ihrem radial außenliegenden Bereich mittels eines äußeren, strahlungsdurchlässigen Rohres miteinander verbunden sein. Weiterhin ist es erfindungsgemäß in besonders vorteilhafter Weise auch möglich, die optischen Elemente so auszubilden, daß sie aus zwei kreissegmentartigen Bereichen, bezogen auf ihren Querschnitt, bestehen, wobei die beiden Sehnen der Kreissegmente aufeinanderliegen. Auch bei einer derartigen Ausgestaltung ist es vorteilhaft, die radial inneren und äußeren Spitzenbereiche abzutrennen und durch konkave bzw. konvexe Bereiche zu ersetzen. Auch derartige optische Elemente können an ihrem äußeren Bereich einstückig mittels eines äußeren Rohres miteinander verbunden werden.

Der erfindungsgemäße Strahlungssammler wurde bereits erfolgreich getestet, wobei der Strahlungssammler oder Kollektor eine wirksame mittlere Fläche von etwa 1,9 m² aufwies. Der Strahlungssammler wurde in einer Verdampfungsanlage zur Trinkwassergewinnung aus Meer- bzw. Brackwasser verwendet, wobei mittels eines Strahlungssammlers oder Kollektors bei einer Einstrahlintensität, wie sie beispielsweise in Riad - Saudi-Arabien - vorherrscht, 160 l/Tag Trinkwasser gewonnen werden konnten. Vergleichbare herkömmliche Sonnenkollektoren ermöglichen, bei gleicher mittlerer wirksamer Fläche, die Gewinnung von lediglich 8 l/Tag. Der erfindungsgemäße Strahlungssammler wies einen Wirkungsgrad von 0,68 auf, woraus sich eine Leistung von 1340 Watt/m² ergibt. Bei einem Einsatz des erfindungsgemäßen Strahlungssammlers zur Prozeßwärmeerzeugung bei einem Konzentrationsfaktor von 1:3 ist es möglich, Temperaturen von ca. 240° C zu erreichen. Bei Verwendung photovoltaischen Zellen und einem Wirkungsgrad von 0,08 war es möglich, bezogen auf die Einstrahlintensität in Riad - Saudi-Arabien-, eine Leistung von 1,64 KwH/Tag und Kollektor zu erzielen.

Im folgenden wird die Erfindung anhand von Ausführungsbeispielen in Verbindung mit der Zeichnung beschrieben. Dabei zeigen:

Fig. 1 eine schematische Darstellung eines Halbquerschnitts eines ersten Ausführungsbeispiels eines erfindungsgemäßen Strahlungssammlers,

Fig. 2 eine Querschnittsansicht, ähnlich Fig. 1, eines weiteren Ausführungsbeispiels,

Fig. 3 eine Querschnittsansicht, ähnlich Fig. 1, eines weiteren Ausführungsbeispiels,

Fig. 4 eine Querschnittsansicht, ähnlich Fig. 1, eines weiteren Ausführungsbeispiels, und

Fig. 5 eine Querschnittsansicht, ähnlich Fig. 1, eines fünften Ausführungsbeispiels.

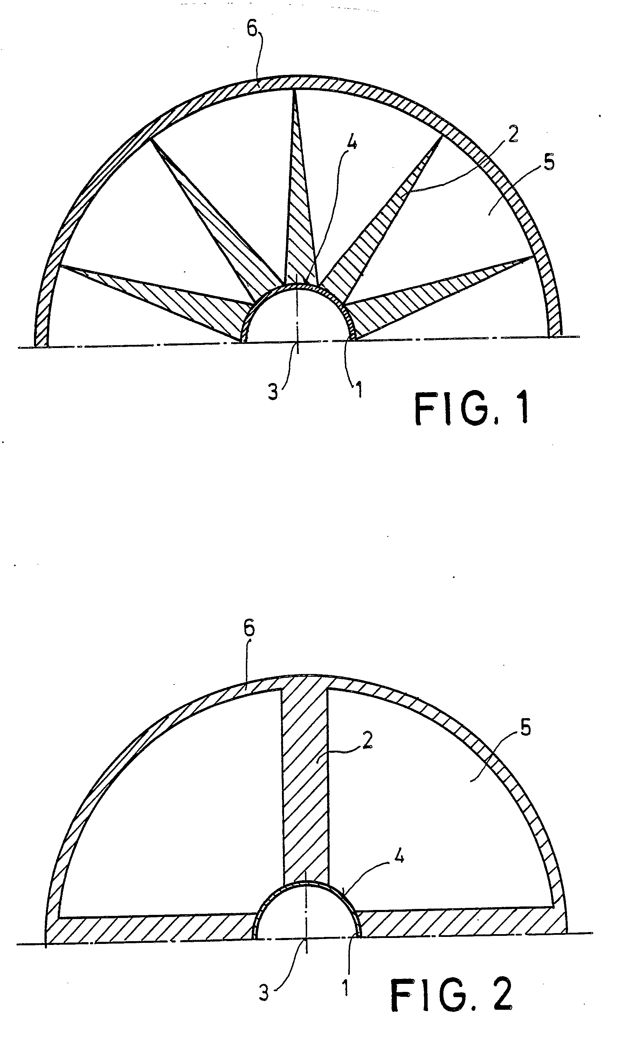

In Fig. 1 ist der Einfachheit halber in schematischer Weise nur die Hälfte des Querschnitts eines ersten Ausführungsbeispiels des erfindungsgemäßen Strahlungssammlers dargestellt. Dieser weist eine Mittelachse 3 auf, welche sowohl die Mittelachse für einen nur schematisch dargestellten rohrförmigen Energiewandler bildet als auch die Mittelachse für ein äußeres Rohr 6, welches konzentrisch zu dem rohrförmigen Energiewandler angeordnet ist und aus einem strahlungsdurchlässigen Material gefertigt ist. In dem Bereich zwischen dem rohrförmigen Energiewandler 1 und dem äußeren Rohr 6 sind mehrere optische Elemente 2 angeordnet, welche über die Länge des Energiewandlers 1 einen gleichbleibenden Querschnitt aufweisen und ih ihrem Querschnitt so ausgestaltet sind, daß sie zwei gleichschenkelige Seiten aufweisen, welche mit der durch sie gebildeten Spitze gegen das äußere Rohr 6 anliegen. Der Basisbereich ist konkav ausgebildet und entspricht in seiner Krümmung der Außenfläche 4 des rohrförmigen Energiewandlers 1. Die Spitzen der optischen Elemente können einstückig mit dem äußeren Rohr 6 versehen sein, wodurch Zwischenräume 5 zwischen den optischen Elementen und dem Rohr 6 zur Umgebung abgeschlossen und untereinander getrennt sind. Es ist jedoch auch möglich, auf das äußere Rohr 6 ganz zu verzichten oder dieses lediglich als Schutzrohr überzuziehen.

In Fig. 2 ist ein weiteres Ausführungsbeispiel dargestellt, bei welchem die optischen Elemente im wesentlichen einen rechteckigen Querschnitt aufweisen und mit einem konkaven Bereich gegen den rohrförmigen Energiewandler 1 anliegen. Das äußere Rohr 6 ist bei diesem Ausführungsbeispiel wiederum mit den optischen Elementen 2 verbunden.

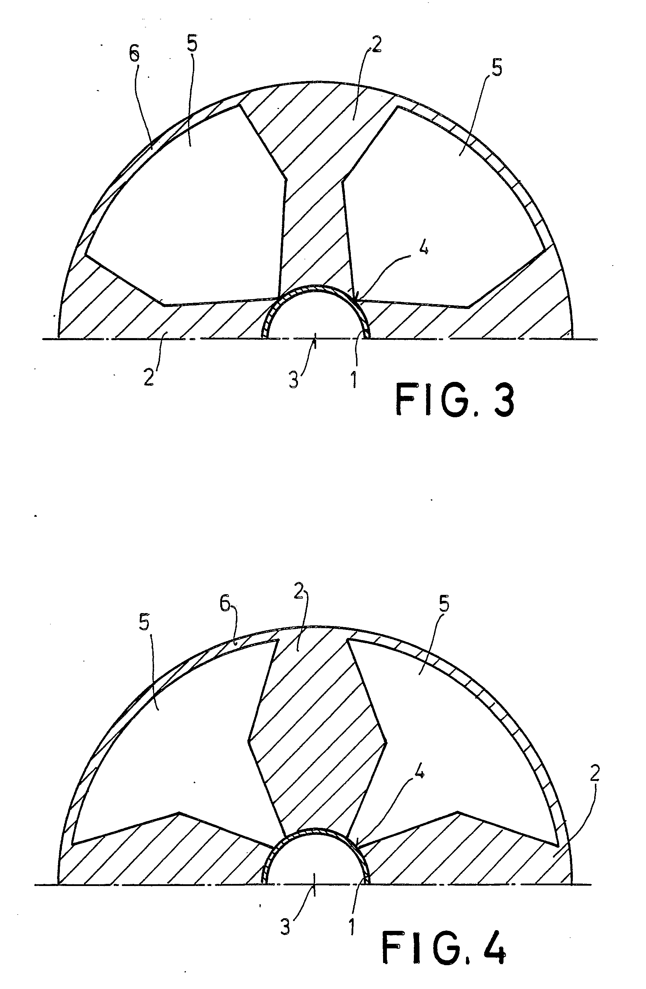

Bei der in Fig. 3 dargestellten Variante sind die optischen Elemente in ihrem Querschnitt so ausgebildet, daß sie aus zwei trapezartigen Bereichen zusammengesetzt sind und sich radial nach außen von dem rohrförmigen Energiewandler 1 aus zunächst verjüngen und dann wiederum mit größerem radialen Abstand verbreitern. Auch bei diesem Ausführungsbeispiel sind die optischen Elemente einstückig mit dem äußeren Rohr 6 verbunden, so daß die Zwischenräume 5 gegeneinander und zur Umgebung hin abgedichtet sind.

Das in Fig. 4 dargestellte Ausführungsbeispiel weist rhombenförmige optische Elemente 2 auf, deren Spitzen jeweils abgetrennt sind und zum rohrförmigen Energiewandler 1 hin konkav und zur Außenfläche hin konvex ausgebildet sind. Auch bei diesem Ausführungsbeispiel sind die optischen Elemente 2 einstückig mittels des Rohres 6 miteinander verbunden.

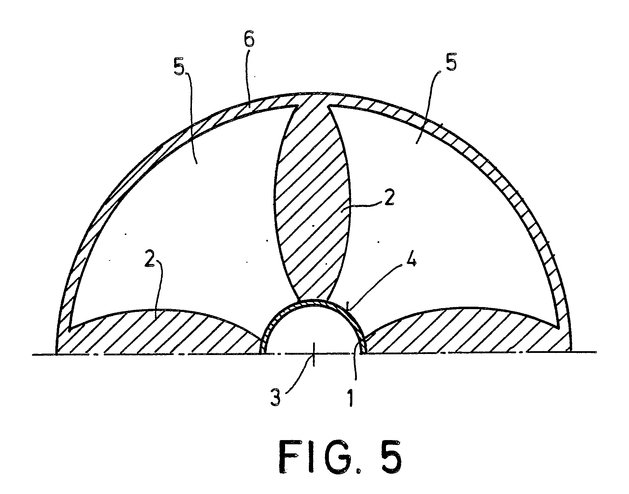

Das in Fig. 5 dargestellte Ausführungsbeispiel ähnelt dem Ausführungsbeispiel von Fig. 4, nur mit der Ausnahme, daß die optischen Elemente 2 nicht rhombenförmig ausgebildet sind, sondern eine Querschnittsfläche aufweisen, die aus zwei Kreissegmenten zusammengesetzt ist, wobei wiederum die radial außen- und innenliegenden Bereiche verkürzt sind und konkav bzw. konvex ausgestaltet sind. Die radial äußeren Enden der einzelnen optischen Elemente 2 gehen wiederum einstückig in das äußere Rohr 6 über.

Die Erfindung ist nicht auf die gezeigten Ausführungsbeispiele beschränkt, vielmehr ist es dem Fachmann im Rahmen der Erfindung möglich, die Ausgestaltung und Abmessung der einzelnen optischen Elemente den jeweiligen Gegebenheiten, insbesondere der Strahlungsart, der Art und Größe des rohrförmigen Energiewandlers anzupassen. Auch ist die Erfindung nicht auf die gezeigte Anzahl und Anordnung der optischen Elemente beschränkt, vielmehr wäre es auch im Rahmen der Erfindung möglich, optische Elemente verschiedener radialer Abmessungen zu verwenden und/oder optische Elemente verschiedener Querschnittsformen in einem Strahlungssammler miteinander zu kombinieren.

## Ansprüche

1. Strahlungssammler mit einem rohrförmigen Energiewandler, gekennzeichnet, durch mehrere, gleichmäßig um den Umfang des Energiewandlers (1) angeordnete, zueinander beabstandete, aus einem strahlungsdurchlässigen Material gefertigte optische Elemente (2), welche jeweils symmetrisch zu einer radialen, die Mittelachse (3) des Energiewandlers (1) umfassenden Ebene ausgebildet sind.

2. Strahlungssammler nach Anspruch 1, dadurch gekennzeichnet, daß die optischen Elemente (2) gegen die Außenfläche (4) des Energiewandlers (1) anliegen.

3. Strahlungssammler nach einem der Ansprüche 1 oder 2, dadurch gekennzeichnet, daß die Zwischenräume (5) zwischen den optischen Elementen (1) mit Gas gefüllt sind.

4. Strahlungssammler nach einem der Ansprüche 1 oder 2, dadurch gekennzeichnet, daß die Zwischenräume (5) zwischen den optischen Elementen (1) evakuiert sind.

5. Strahlungssammler nach einem der Ansprüche 1 bis 4, dadurch gekennzeichnet, daß die optische Elemente (2) innerhalb eines strahlungsdurchlässigen, zum rohrförmigen Energiewandler konzentrischen Rohres (6) angeordnet sind.

6. Strahlungssammler nach Anspruch 5, dadurch gekennzeichnet, daß die optischen Elemente (2) einstückig mit dem Rohr (6) ausgebildet sind.

7. Strahlungssammler nach einem der Ansprüche 1 bis 6, dadurch gekennzeichnet, daß der Außendurchmesser der optischen Elemente (2), bezogen auf die Mittelachse (3) des rohrförmigen Energiewandlers (1), zu dem Außendurchmesser des Energiewandlers (1) in einem Verhältnis von mindestens 2 : 1 steht.

8. Strahlungssammler nach einem der Ansprüche 1 bis 7, dadurch gekennzeichnet, daß die optischen Elemente (2) an einigen ihrer Seitenflächen verspiegelt sind.

9. Strahlungssammler nach einem der Ansprüche 1 bis 8, dadurch gekennzeichnet, daß der Energiewandler (1) in Form eines Wärmetauscherrohres ausgebildet ist.

10. Strahlungssammler nach einem der Ansprüche 1 bis 8,
dadurch gekennzeichnet,
daß der Energiewandler (1) mit photovoltaischen Zellen versehen ist.

11. Strahlungssammler nach Anspruch 10,
dadurch gekennzeichnet,
daß die photovoltaischen Zellen mit einem Wärmetauscherrohr in Kontakt sind.

12. Strahlungssammler nach einem der Ansprüche 10 oder 11,
dadurch gekennzeichnet,
daß die photovoltaischen Zellen auf einem Trägerrohr befestigt sind, welches passend in ein strahlungsdurchlässiges, zentrisch zu den optischen Elementen angeordnetes Rohr eingeführt ist.

13. Strahlungssammler nach einem der Ansprüche 1 bis 12,
dadurch gekennzeichnet,
daß jedes optische Element (2) sich über die gesamte Länge des rohrförmigen Energiewandlers (1) erstreckt und über seine Länge einen gleichbleibenden Querschnitt aufweist.

14. Strahlungssammler nach einem der Ansprüche 1 bis 13,
dadurch gekennzeichnet,
daß jedes optische Element (2) in Form eines gleichschenkligen Dreiecks ausgebildet ist, dessen durch die gleichen Schenkel gebildete Spitze dem rohrförmigen Energiewandler (1) zugewandt ist und dessen Basis in Form eines konvexen Kreisbogenausschnittes ausgebildet ist.

15. Strahlungssammler nach einem der Ansprüche 1 bis 13,
dadurch gekennzeichnet,
daß das optische Element (2) einen rechteckförmigen Querschnitt aufweist, wobei die radiale Länge größer ist als die Breite des optischen Elements (2), wobei die dem rohrförmigen Energiewandler (1) zugewandte Seite konkav ausgebildet ist.

16. Strahlungssammler nach einem der Ansprüche 1 bis 13,
dadurch gekennzeichnet,
daß das optische Element im Querschnitt zwei trapezförmige Bereiche umfaßt, wobei die radial innenliegende Fläche des inneren Trapezes, welche dem rohrförmigen Energiewandler (1) zugewandt ist, konkav ausgebildet ist und wobei sich die trapezförmige Gestalt in radialer Richtung vom rohrförmigen Energiewandler (1) weg verjüngt und wobei der außenliegende trapezförmige Bereich, welcher in den innenliegenden trapezförmigen Bereich übergeht, radial nach außen hin erweitert ausgebildet ist und eine konvexe Außenfläche aufweist.

17. Strahlungssammler nach einem der Ansprüche 1 bis 13,
dadurch gekennzeichnet,
daß das optische Element (2) im wesentlichen einen rhombusförmigen Querschnitt aufweist, wobei der dem rohrförmigen Energiewandler (1) zugewandte Spitzenbereich des Rhombus verkürzt und konkav ausgebildet ist, während der radial abgewandte Bereich verkürzt und konvex ausgebildet ist.

18. Strahlungssammler nach einem der Ansprüche 1 bis 13,
dadurch gekennzeichnet,
daß das optische Element (2) eine Querschnittsform aufweist, welche aus zwei mit ihren Basisbereichen gegeneinander anliegenden Kreissegmenten gebildet ist, wobei die radial innenliegenden Bereiche der Kreissegmente verkürzt und konkav ausgebildet sind, während die radial außenliegenden Bereiche verkürzt und konvex ausgestaltet sind.

FIG. 1

FIG. 2

FIG. 3

FIG. 4

FIG. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-1 989 999 (NIEDERLE) <br> * Seite 2, linke Spalte, Zeilen 10-42; Seite 2, rechte Spalte, Zeilen 5-39; Seite 2, rechte Spalte, Zeile 74 - Seite 3, linke Spalte, Zeile 25; Figuren 3,9 * | 1,3-6,9 ,13 | F 24 J 2/06 <br> F 24 J 2/04 <br> H 01 L 31/00 |
| Y | | 2,8,10-12,14 | |
| A | --- | 7,15-18 | |
| Y | DE-A-2 738 667 (MASCHINENFABRIK AUGSBURG-NÜRNBERG AG) <br> * Seite 17, Zeilen 8-17; Seite 20, Zeile 8 - Seite 21, Zeile 12; Figuren 1,6,9,10 * <br> --- | 2,8,14 | |
| Y | US-A-4 700 013 (SOULE) <br> * Spalte 1, Zeile 63 - Spalte 2, Zeile 61; Figur 1 * <br> --- | 10-12 | |
| A | US-A-4 505 260 (METZGER) <br> * Spalte 6, Zeilen 1-59; Figur 3 * <br> --- | 1,5,9, 13,14 | RECHERCHIERTE SACHGEBIETE (Int. Cl.4) |
| A | PATENT ABSTRACTS OF JAPAN, Band 8, Nr. 262 (M-341)[1699], 30. November 1984; & JP-A-59 131 853 (MASAICHI KANAYAMA) 28-07-1984 <br> --- | 1 | F 24 J <br> H 01 L |
| A | EP-A-0 004 060 (RODLER) <br> * Seite 4, Zeilen 1-11; Figur 1 * <br> --- | 1,5,6 | |
| A | US-A-4 394 859 (DROST) <br> * Spalte 3, Zeile 43 - Spalte 4, Zeile 24; Figur 2 * <br> ----- | 1,8,13, 14 | |

Der vorliegende Recherchenbericht wurde für alle Patentansprüche erstellt

| Recherchenort | Abschlußdatum der Recherche | Prüfer |
|---|---|---|
| DEN HAAG | 02-05-1989 | BELTZUNG F.C. |